# EUROPEAN PATENT APPLICATION

(11) **EP 1 592 262 A2**
(43) Date of publication of application: **02.11.2005**
(21) Application number: 05005977.3
(22) Date of filing: 18.03.2005
(51) Int. Cl.: H04N 9/64

(54) **Video signal processing apparatus**

(30) Priority: 31.03.2004 JP 2004102507
(71) Applicant: Pioneer Corporation, Meguro-ku, Tokyo (JP)
(72) Inventor: Kawaguchi, Hirofumi, c/o Pioneer Ohmori Plant, Tokyo (JP); Nagakubo, Tetsuro, Tokyo (JP)
(74) Representative: Klingseisen, Franz

(57) **Abstract**

Disclosed is a video signal processing apparatus which adequately calibrates a gain for each of plural types of input video signals. In calibration mode, a reference signal corresponding to each of plural types of input video information is supplied in place of an input video signal, and the variable gains of demodulation signal paths to a demodulation stage are updated in such a way that the detection level of a demodulated output signal obtained for each demodulation signal path at the time of signal supply falls within a target range, the acquired updated values are respectively stored for the associated input video signals. In normal demodulation mode, the gain with the latest updated value is used.

## Description

### BACKGROUND OF THE INVENTION

### 1. Field of the Invention

The present invention relates to a video signal processing apparatus which selectively demodulates one of plural types of video information signals, such as a composite analog video signal, a separate analog video signal, a Y-C component signal and an RGB analog signal.

### 2. Description of the Related Art

With recent advancement of video equipment, it becomes popular to connect various video equipment, such as a TV signal reception tuner, a DVD player and a VTR, as video signal sources, to a single display device in parallel, and to use a video signal processing apparatus which performs composite process on a selected one of plural types of video information signals, such as a composite analog video signal, a separate analog video signal, a Y-C component signal and an RGB analog signal supplied from the video equipment, yielding an RGB signal, then supply the RGB signal to the display device to reproduce the video signal.

Such a video signal processing apparatus sets a demodulation signal path for each input video information signal to be selected, and requires that the circuit constants should be adjusted for each of the plural demodulation signal paths at the time of shipping or repairing the video signal processing apparatus, thus resulting in a larger number of steps involved in the adjustment and the repair.

### SUMMARY OF THE INVENTION

Accordingly, the above-mentioned problem is one of the problems that the present invention intends to overcome.

The invention defined in Claim 1 comprises:
selective relay means which selects one of plural types of video information signals supplied thereto according to a select command, and relays the selected video information signal;
variable gain amplifier and A/D conversion means which amplifies and performs A/D conversion of the selected video information signal having gone through the selective relay means by a designated gain;
demodulation means which sets a demodulation path according to a path designation command, and demodulates a digital output from the variable gain amplifier and A/D conversion means, thereby yielding a demodulated output signal; and
control means which adjusts the gain of the variable gain amplifier and A/D conversion means, and includes select command generating means which generates the select command according to an external instruction, path designation means which generates the path designation command in response to the select command, reference signal generating/supplying means which generates a reference video signal according to a content of the path designation command and supplies the reference video signal, in place of the selected video information signal, to the variable gain amplifier and A/D conversion means only for an adjustment period, level detection means which detects a signal level of a video output signal acquired by demodulating the reference video signal by the demodulation means, memory means which stores a gain acquired by adjusting the gain of the variable gain amplifier and A/D conversion means in such a way that the signal level detected by the level detection means falls within a target range, and gain setting means which sets the gain of the variable gain amplifier and A/D conversion means according to the gain stored in the memory means.

### BRIEF DESCRIPTION OF THE DRAWINGS

Fig. 1 is a block diagram showing a video signal demodulating apparatus according to a first embodiment of the invention;
Fig. 2 is a flowchart illustrating the gain calibration operation of the video signal demodulating apparatus in Fig. 1;
Fig. 3 is a block diagram showing a video signal demodulating apparatus according to a second embodiment of the invention;
Fig. 4 is a flowchart illustrating the gain calibration operation of the video signal demodulating apparatus in Fig. 3;
Fig. 5 is a block diagram showing a video signal demodulating apparatus according to a third embodiment of the invention;
Fig. 6 is a flowchart illustrating the gain calibration operation of the video signal demodulating apparatus in Fig. 5;
Fig. 7 is a block diagram showing a video signal demodulating apparatus according to a fourth embodiment of the invention;
Fig. 8 is a block diagram showing a video signal demodulating apparatus according to a fifth embodiment of the invention; and
Fig. 9 is a block diagram showing a video signal demodulating apparatus according to a sixth embodiment of the invention.

### DETAILED DESCRIPTION OF THE INVENTION

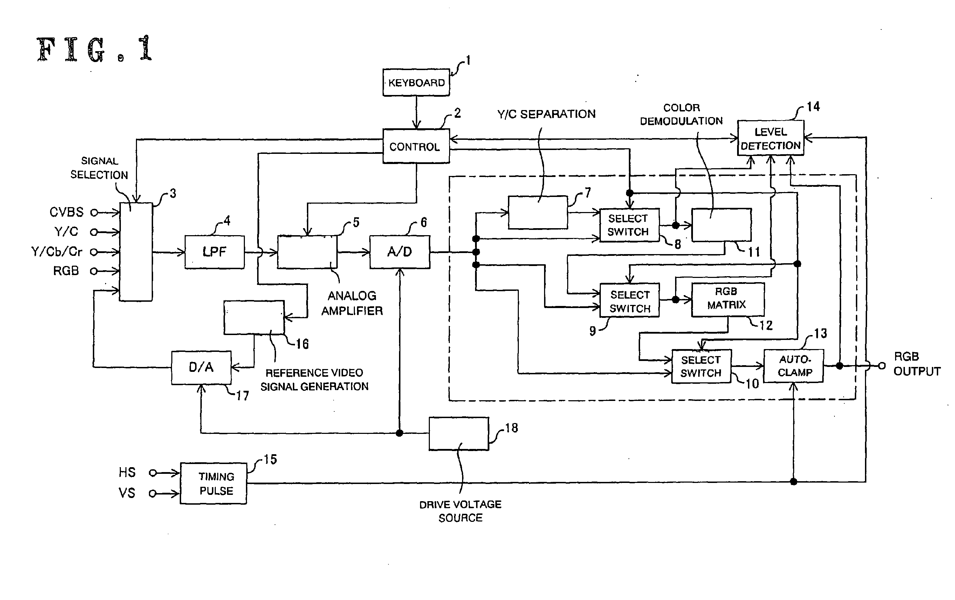

Fig. 1 shows a video signal processing apparatus according to the first embodiment of the invention. In response to a command supplied via input means like a keyboard 1, the video signal processing apparatus performs adequate demodulation on one of plural types of video signals, such as a composite analog video signal (hereinafter abbreviated as "CVBS signal"), a separate analog video signal (hereinafter abbreviated as "Y/C signal"), a Y-C component signal (hereinafter abbreviated as "Y/Cb/Cr signal"), and an RGB analog signal (hereinafter abbreviated as "RGB signal"), to acquire an RGB signal, and supplies the RGB signal to a drive circuit (not shown) for a display device, or the like, located at the subsequent stage.

In the apparatus in Fig. 1, a signal selection circuit 3 receives a CVBS signal, a Y/C signal, a Y/Cb/Cr signal, and an RGB signal as input signals, and selectively relays one of the input signals to the next stage in response to a select command from a control circuit 2 which performs a control operation according to a manual input made through, for example the keyboard 1. The video signal selected by the signal selection circuit 3 undergoes a process, such as anti-aliasing, by a low-pass filter 4 and is then supplied to a variable gain analog amplifier 5. The analog amplifier 5 amplifies an input video signal with a gain which is determined according to a gain designation command supplied from the control circuit 2. The output signal of the analog amplifier 5 is supplied to an A/D conversion circuit 6. The A/D conversion circuit 6 digitizes the supplied video signal. The digital video signal is supplied to the input terminal of a Y/C separation circuit 7, one input terminal of a select switch circuit 8, one input terminal of a select switch circuit 9, and one input terminal of a select switch circuit 10. When the supplied digital video signal is a composite video signal, the Y/C separation circuit 7 separates and extracts a luminance (Y) component and a color (C) component from the composite video signal, and supplies extracted components as luminance/color (Y/C) signal to the other input terminal of the select switch circuit 8. The select switch circuit 8 selectively relays one of the signals supplied to the input terminal in response to the select command from the control circuit 2.

Having information on the type of the video signal currently selected by the signal selection circuit 3, the control circuit 2 controls the select switch circuit 8 according to the information. Specifically, the control circuit 2 selects the output of the Y/C separation circuit 7 and relays the output when the selected input video signal is a CVBS signal, and relays the output signal of the A/D conversion circuit 6 as it is and supplies the output signal to a color demodulation circuit 11 when the selected input video signal is a Y/C signal. Therefore, the color demodulation circuit 11 is supplied with the luminance/color (Y/C) signal. The color demodulation circuit 11 performs color demodulation on the input signal to generate a Y/Cb/Cr signal, and supplies the Y/Cb/Cr signal to the other input terminal of the select switch circuit 9. Under the control of the control circuit 2, the select switch circuit 9 relays the output of the color demodulation circuit 11 when the selected input video signal is a CVBS signal or a Y/C signal, and relays the output of the A/D conversion circuit 6 when the selected input video signal is a Y/Cb/Cr signal. Therefore, the select switch circuit 9 is controlled by the control circuit 2 which supplies the Y/Cb/Cr signal to an RGB matrix circuit 12.

The RGB matrix circuit 12 performs an arithmetic operation on the supplied Y/Cb/Cr signal according to predetermined operation rules to generate an RGB signal comprised of a red (R) component, a green (G) component and a blue (B) component, and supplies the RGB signal to one input terminal of the select switch circuit 10. The select switch circuit 10 is controlled in such a way as to relay the output of the RGB matrix circuit 12 when the selected input video signal is other than an RGB signal and to relay the output of the A/D conversion circuit 6 when the selected input video signal is an RGB signal, and sends the RGB signal to an auto-clamp circuit 13. The auto-clamp circuit 13 clamps the signal level of a pedestal period, which is discriminated by a timing pulse generated by a timing pulse generation circuit 15 based on horizontal and vertical sync signals HS and VS of the input video signal, to a reference clamp level. The RGB signal auto-clamped this way is supplied to a display drive circuit (not shown) at the subsequent stage.

While the horizontal and vertical sync signals HS and VS are extracted from the input video signal by a sync separation circuit (not shown), the extraction is a well-known technique and will not be discussed below.

A level detection circuit 14 detects the signal level of the RGB signal acquired as the result of the video signal processing as discussed above. The level detection circuit 14 can detect the level of only the Y signal in the output of the select switch circuit 8, and the signal level of the Y/Cb/Cr signal output from the select switch circuit 9. When detecting the signal level of the Y signal or the Y/Cb/Cr signal, the level detection circuit 14 performs the desired level detection operation by discriminating the pedestal period based on the timing pulse from the timing pulse generation circuit 15, clamping the pedestal period to a reference level and detecting a signal level of the remaining portion.

The level detection circuit 14 supplies the control circuit 2 with data of the level of one of the RGB signal, the Y/Cb/Cr signal and the Y signal in response to a command from the control circuit 2.

When a command calibration mode is instructed through the keyboard 1, the control circuit 2 instructs a reference video signal generating circuit 16 to generate a digital reference video signal. The reference video signal generated by the reference video signal generating circuit 16 is supplied to a D/A conversion circuit 17. The D/A conversion circuit 17 supplies an analog reference video signal to one input terminal of the signal selection circuit 3. At this time, the control circuit 2 instructs the signal selection circuit 3 to relay an analog reference video signal, so that the analog reference video signal is supplied to the input terminal of the analog amplifier 5. The reference video signal is a reference signal corresponding to each of a CVBS signal, a Y/C signal, a Y/Cb/Cr signal and an RGB signal as input video signals, and the reference video signal generating circuit 16 generates a reference video signal of the type that corresponds to the type information of the designated input video signal included in a reference video signal generation command from the control circuit 2.

It is preferable that the A/D conversion circuit 6 and the D/A conversion circuit 17 should be driven by a common drive voltage source 18. This allows the A/D conversion circuit 6 to absorb a change in the voltage of the reference video signal originated from a change in drive voltage after D/A conversion of the reference video signal. It is therefore preferable that the A/D conversion circuit 6, the D/A conversion circuit 17, the reference video signal generating circuit 16 and the drive voltage source 18 should be constructed as a single circuit block.

The circuit structure that replaces an analog reference video signal with an input video signal is not limited to the signal selection circuit 3, but may take such a structure as to dispose a changeover switch circuit (not shown) between the signal selection circuit 3 and the analog amplifier 5.

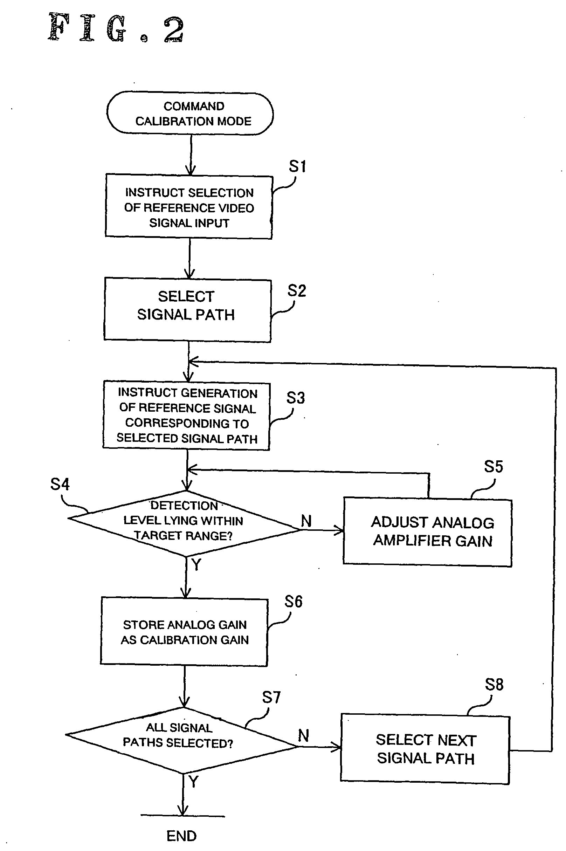

The control operation of the control circuit 2 will be discussed referring to the flowchart of Fig. 2.

The flowchart of Fig. 2 illustrates the operation of a command calibration mode when the control circuit 2 is instructed to execute a calibration mode through the keyboard 1. The calibration mode is, for example, the mode that is executed by a service man when performing adjustment at the time of shipment from a factory or when the apparatus is sited at home.

In the command calibration mode, the control circuit 2 first supplies a command to select a reference video signal input to the signal selection circuit 3 (step S1). Next, the control circuit 2 drives the select switch circuits 8, 9 and 10 to select one demodulation signal path for demodulation of, for example, a CVBS signal (step S2). Then, the control circuit 2 instructs the reference video signal generating circuit 16 to generate a reference video signal corresponding to the selected demodulation signal path (step S3). At this time, the control circuit 2 fetches the detection signal level of the RGB output signal obtained from the level detection circuit 14, and discriminates whether the detection signal level lies within a certain target range or not (step S4). When the detection signal level does not lie within the target range, the control circuit 2 adjusts the gain of the analog amplifier 5 (step S5). When the detection signal level of the RGB output lies within the target range as a consequence of the gain adjustment, the control circuit 2 stops the gain adjustment of the analog amplifier 5 and stores the then analog gain as a calibration gain in association with the selected demodulation signal path or the type of the input video signal (step S6).

Next, the control circuit 2 discriminates whether the level detection of the RGB output signal has been done for all the demodulation signal paths or not (step S7). When the level detection has not been done for all the demodulation signal paths, the control circuit 2 selects a next signal path and returns to the step S3. When the level detection and the update of the calibration gain have finished for all the demodulation signal paths, the calibration mode is terminated.

With the values of the thus obtained adequate amplifier gains corresponding to the input video signals stored, the latest adequate amplifier gain value stored for each input video signal selected by a user is read and a gain of the analog amplifier 5 is set according to the gain value. Therefore, the optimal RGB output level is acquired regardless of the type of an input video signal to be selected.

It is also possible to control optimization of the level of an input signal to the color demodulation circuit 11 or optimization of the level of an input signal to the RGB matrix circuit 12 by adjusting the gain of the analog amplifier according to the detection signal level of the output signal of the select switch circuit 8 or the select switch circuit 9.

A CVBS signal, a Y/C signal, a Y/Cb/Cr signal or an RGB signal which represents a raster signal, a lamp signal or a step signal of 100IRE level may be used as the reference video signal.

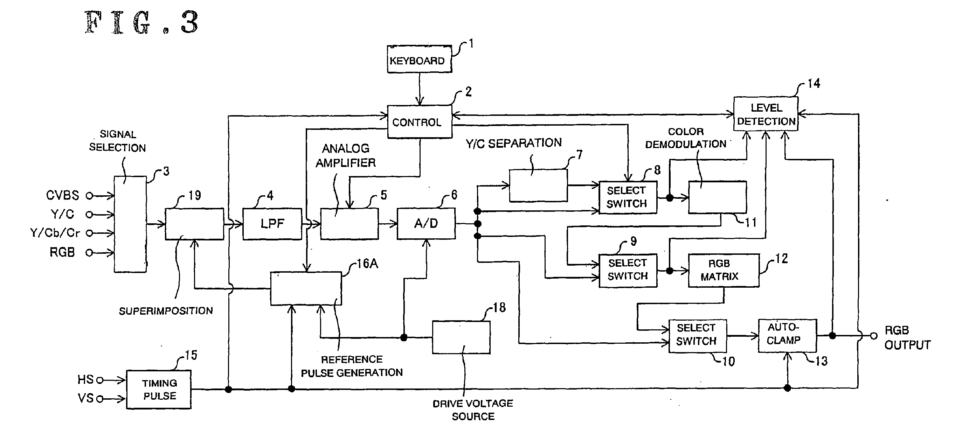

Fig. 3 shows a video signal processing apparatus according to the second embodiment of the invention.

The video signal processing apparatus in Fig. 3 includes a reference pulse generation circuit 16A in place of the reference video signal generating circuit 16 in Fig. 1. For the reference pulse generation circuit 16A, there is preferred a rectangular pulse whose pulse amplitude is one of sizes defined by, for example, 100IRE, 50IRE, 20IRE and OIRE and is shorter than one horizontal period, and which is generated at a timing in one horizontal period of the vertical blanking period of each input video signal. The video signal processing circuit in Fig. 3 further has a superimposing circuit 19 provided between the signal selection circuit 3 and the low-pass filter 4, so that a reference pulse generated by the reference pulse generation circuit 16A is inserted into one horizontal period in the vertical blanking period of the input video signal selected by the signal selection circuit 3. This can be said to be replacement of one horizontal period portion of the input video signal with the reference pulse. It is therefore apparent that the superimposing circuit 19 may be a changeover switch (not shown) which changes over between the output of the signal selection circuit 3 and the reference pulse and relays the selected one to the subsequent stage.

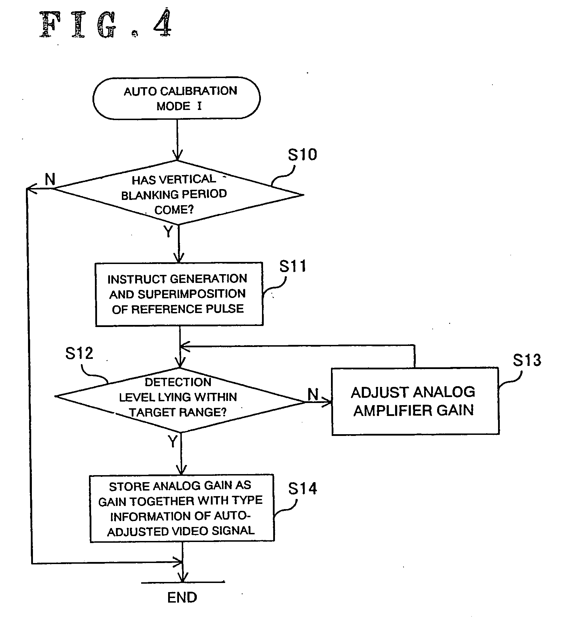

The operation of the control circuit 2 in the video signal processing apparatus in Fig. 3 is the same as that of the control circuit 2 in Fig. 1 except that the former control circuit 2 can execute an auto calibration mode I illustrated in the flowchart in Fig. 4.

When receiving a command of an auto calibration mode through, for example, the keyboard 1, the control circuit 2 in Fig. 3 executes the auto calibration mode I shown in Fig. 4. In this auto calibration mode, first, the control circuit 2 discriminates based on the timing pulse from the timing pulse generation circuit 15 whether the vertical blanking period in the input video signal has come or not (step S10). When it is detected that the vertical blanking period in the input video signal has come, the control circuit 2 instructs the reference pulse generation circuit 16A to generate the reference pulse (step S11). Then, the reference pulse generation circuit 16A generates the reference pulse and supplies the pulse to the superimposing circuit 19. The superimposing circuit 19 superimposes the received reference pulse on the input video signalÿ selected by the signal selection circuit 3, in an adequate horizontal sync period, such as the last horizontal sync period, in the vertical blanking period. Then, the control circuit 2 discriminates whether or not the detection level of the RGB output to be detected by the level detection circuit 14 in the period corresponding to the reference pulse lies within the target range (step S12). When having determined that the detection level does not lie within the target range, the control circuit 2 adjusts and updates the gain of the analog amplifier 5 and returns to the operation of step S12 (step S13). When having determined that the detection level lies within the target range as a result of updating the gain of the analog amplifier 5, the control circuit 2 stores the then updated gain of the analog amplifier 5 in association with the type information of the then selected input video signal (step S14).

Based on the latest update value of the gain of the analog amplifier 5 obtained this way, the normal demodulation operation on the selected the input video signal is executed. What is more, the auto calibration mode I shown in Fig. 4 is desirable for it is executed in the vertical blanking period of the input video signal, so that the mode does not interfere with the demodulation operation of the input video signal and can be executed in parallel to the normal demodulation operation.

Since the operation of the control circuit 2 in Fig. 3 is the same as that of the control circuit 2 in Fig. 1 except for the aforementioned points, the structures and operations for the same components will be omitted.

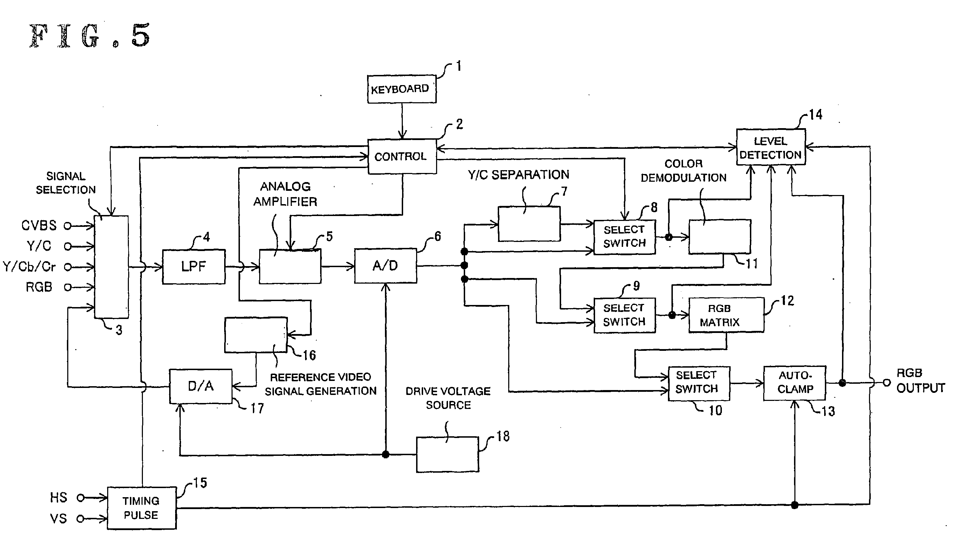

Fig. 5 shows a video signal processing apparatus according to the third embodiment of the invention. The circuit structure and operation of the video signal processing apparatus are the same as those of the video signal processing apparatus in Fig. 1 except that the control circuit 2 controls the signal selection circuit 3 in such a way as to insert or replace the reference video signal from the reference video signal generating circuit 16 only in, for example, the last horizontal sync period in the vertical blanking period of the selected input video signal. To perform such control operation, the control circuit 2 controls the signal selection circuit 3 according to the timing pulse from the timing pulse generation circuit 15.

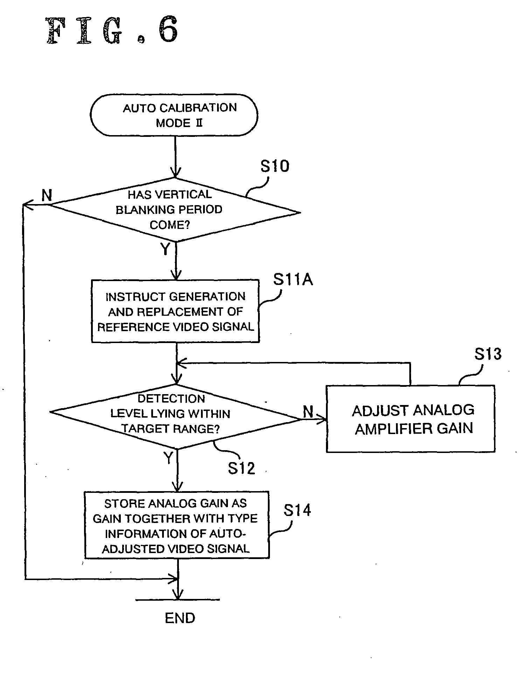

Such operation of the control circuit 2 can be called "auto calibration mode II" which is illustrated in Fig. 6. This operation mode is the same as the operation mode in Fig. 4 except that a command for generation and replacement of the reference video signal is issued at step S11A in place of the reference pulse generation/replacement command.

The gain of the analog amplifier 5 is set by the control circuit 2 according to the latest update value of the gain of the analog amplifier 5 obtained by executing the auto calibration mode II, and a demodulation process is performed on the selected input video signal.

It is apparent that the structure that changes over an analog reference video signal to an input video signal in one horizontal sync period can be achieved by a changeover switch circuit (not shown) inserted between the signal selection circuit 3 and the analog amplifier 5.

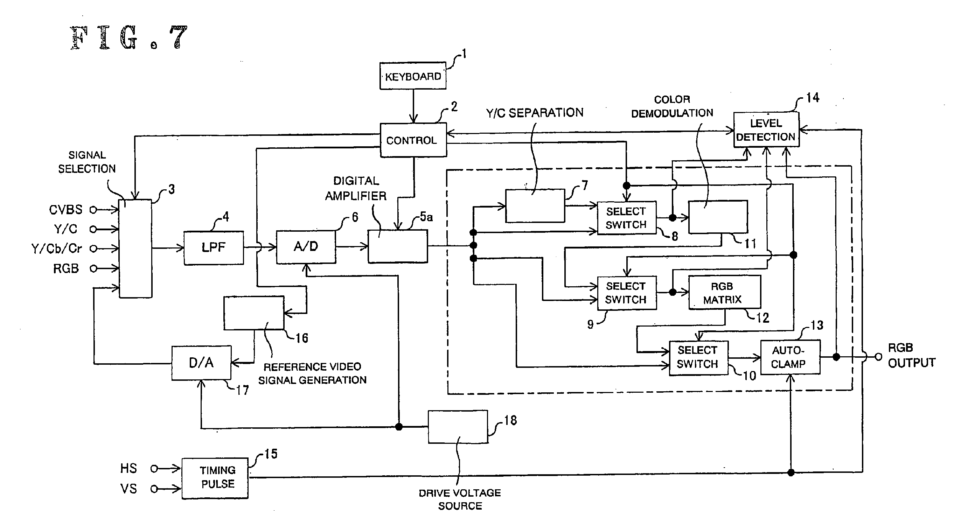

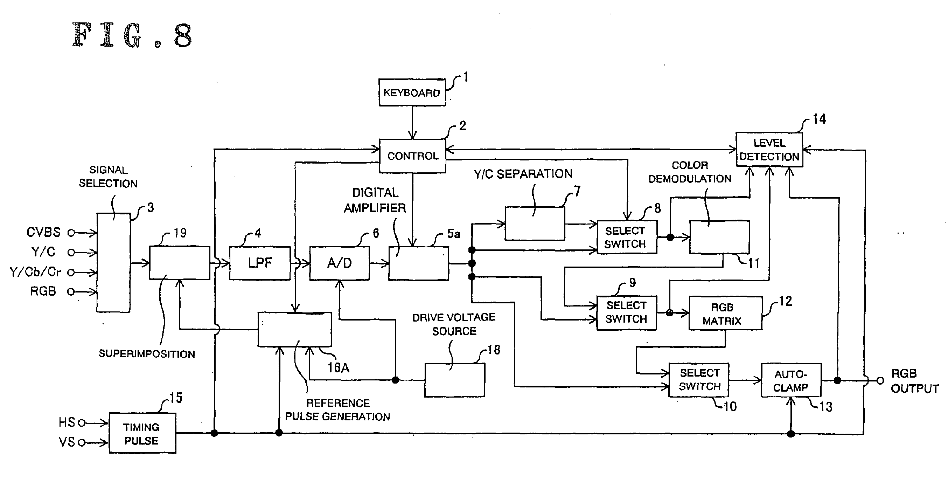

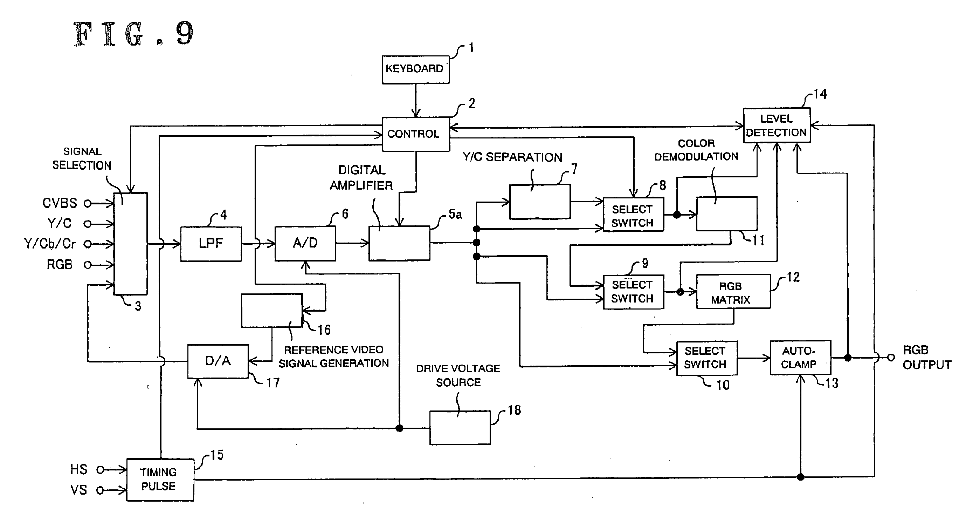

Figs. 7 through 9 illustrate video signal demodulating apparatuses according to fourth to sixth embodiments of the invention. Those video signal demodulating apparatuses have the same circuit structures as that of the video signal demodulating apparatuses according to the first to third embodiments except that the apparatuses of the fourth to sixth embodiments are constructed in such a way as to cause a digital amplifier 5a to amplify a digital video signal acquired after A/D conversion of the output signal of the low-pass filter 4 by the A/D conversion circuit 6, and the control circuit 2 is constructed to adjust the gain of the digital amplifier 5a. The operation of the control circuit 2 is the same as those of the control circuits 2 of the first to third embodiments except that the operations at steps S5 and S13 are adjustment of the digital amplifier gain.

## Claims

1. A video signal processing apparatus comprising:
a selective relay part which selects one of plural types of video information signals supplied thereto according to a select command, and relays said selected video information signal;
a variable gain amplifier and A/D conversion part which amplifies said selected video information signal by a designated gain, and performs A/D conversion of said selected video information signal;
a demodulation part which sets a demodulation path according to a path designation command, and demodulates a digital output from said variable gain amplifier and A/D conversion part, thereby yielding a demodulated output signal; and
a control part which adjusts said gain of said variable gain amplifier and A/D conversion part,
wherein said control part includes a select command generating part which generates said select command according to an external instruction, a path designation part which generates said path designation command in response to said select command, a reference signal generating/supplying part which generates a reference video signal according to a content of said path designation command and supplies said reference video signal, in place of said selected video information signal, to said variable gain amplifier and A/D conversion part for an adjustment period, a level detection part which detects a signal level of a video output signal acquired by demodulating said reference video signal by said reference signal generating/supplying part, a memory part which stores a gain acquired by adjusting said gain of said variable gain amplifier and A/D conversion part in such a way that said signal level detected by said level detection part falls within a target range, and a gain setting part which sets said gain of said variable gain amplifier and A/D conversion part according to said gain stored in said memory part.

2. The video signal processing apparatus according to claim 1, wherein said select command generating part generates said select command according to a manual input.

3. The video signal processing apparatus according to claim 1, wherein said variable gain amplifier and A/D conversion part comprises:
a variable gain analog amplifier which amplifies an output of said selective relay part with a variable gain controlled by said control part; and
an A/D conversion circuit which performs A/D conversion of an output of said variable gain analog amplifier.

4. The video signal processing apparatus according to claim 1, wherein said variable gain amplifier and A/D conversion part comprises:
an A/D conversion circuit which performs A/D conversion of an output of said selective relay part; and
a variable gain digital amplifier which amplifies an output of said A/D conversion circuit selective with a variable gain controlled by said control part.

5. The video signal processing apparatus according to claim 1, wherein said demodulation part comprises a Y-C separation circuit, a color demodulation circuit, an RGB matrix circuit, and switches which switch connection among said Y-C separation circuit, said color demodulation circuit, and said RGB matrix circuit, and said path designation command is a drive command to selectively drive said switches.

6. The video signal processing apparatus according to claim 1, wherein said reference signal generating/supplying part generates, as said reference signal, a reference pulse whose amplitude represents a predetermined luminance level, and inserts said reference pulse in a blanking period of said video information signal.

7. The video signal processing apparatus according to claim 1, wherein said reference signal generating/supplying part generates, as said reference signal, a video signal of at least one horizontal period, and inserts said reference pulse in a blanking period of said video information signal.

8. The video signal processing apparatus according to claim 1, wherein said reference signal generating/supplying part generates, as a reference video signal, a reference video signal of a same kind as said selected video information signal, and supplies said reference video signal to an analog amplifier in place of said selected video information signal.

9. The video signal processing apparatus according to claim 1, wherein said reference signal generating/supplying part comprises:
a reference signal generating part which generates a digital video signal; and
a D/A converter which converts said digital video signal to an analog video signal and whose power source is shared by an A/D converter.
